(19) Europäisches Patentamt
European Patent Office
Office européen des brevets

(11) **EP 3 365 270 B1**

(12) **FASCICULE DE BREVET EUROPEEN**

(45) Date de publication et mention de la délivrance du brevet:
**08.01.2020 Bulletin 2020/02**

(21) Numéro de dépôt: **16785122.9**

(22) Date de dépôt: **20.10.2016**

(51) Int Cl.:
***B81B 3/00*** *(2006.01)*

(86) Numéro de dépôt international:
**PCT/EP2016/075188**

(87) Numéro de publication internationale:
**WO 2017/068025 (27.04.2017 Gazette 2017/17)**

(54) **STRUCTURE MICROELECTROMECANIQUE ET/OU NANOELECTROMECANIQUE A ACTIONNEMENT ELECTROTHERMIQUE OFFRANT UN RENDEMENT AMELIORE**

ELEKTROTHERMISCH BETÄTIGTE MIKROELEKTROMECHANISCHE UND/ODER NANOELEKTROMECHANISCHE STRUKTUR MIT ERHÖHTER EFFIZIENZ

ELECTROTHERMALLY ACTUATED MICROELECTROMECHANICAL AND/OR NANOELECTROMECHANICAL STRUCTURE PROVIDING INCREASED EFFICIENCY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.10.2015 FR 1560043**

(43) Date de publication de la demande:
**29.08.2018 Bulletin 2018/35**

(73) Titulaires:
• **Commissariat à l'Energie Atomique et aux Energies Alternatives**
**75015 Paris (FR)**
• **SAFRAN ELECTRONICS & DEFENSE**
**92100 Boulogne Billancourt (FR)**

(72) Inventeurs:
• **JOURDAN, Guillaume**
**38000 Grenoble (FR)**
• **LEHEE, Guillaume**
**92100 Boulogne Billancourt (FR)**

(74) Mandataire: **Brevalex**
**95, rue d'Amsterdam**
**75378 Paris Cedex 8 (FR)**

(56) Documents cités:
**EP-A1- 2 711 696       EP-A2- 2 322 971**
**US-A1- 2015 047 078    US-B1- 6 675 578**

EP 3 365 270 B1

## Description

## DOMAINE TECHNIQUE ET ÉTAT DE LA TECHNIQUE ANTÉRIEURE

La présente invention se rapporte à une structure microélectromécanique et/ou nanoélectromécanique à actionnement électrothermique offrant un rendement amélioré, par exemple pour réaliser un actionneur ou un capteur.

Les systèmes microélectromécaniques (MEMS pour Microelectromechanical systems en terminologie anglo-saxonne) et/ou nanoélectromécaniques (NEMS pour Nanoelectromechanical systems en terminologie anglo-saxonne) comportent une partie fixe et au moins une partie mobile et des moyens d'actionnement pour mettre en mouvement la partie mobile par rapport à la partie fixe

Le dispositif d'actionnement peut être de différents types.

Le dispositif d'actionnement peut être de type électrostatique, comportant des électrodes d'actionnement, par exemple sous forme de peignes capacitifs ou d'électrodes en regard, qui occupent un espace important et qui peuvent être de tailles comparables à celle du MEMS ou du NEMS. En outre, l'intensité de la force capacitive décroit fortement lorsque les dimensions du MEMS ou du NEMS se réduisent. De plus l'actionnement électrostatique nécessite des espaces inter électrodes inférieures à quelques $\mu$m afin de pouvoir générer des forces suffisamment importantes. Ces espaces inter électrodes constituent souvent l'une des principales sources de dissipation d'énergie mécanique dans les MEMS et NEMS qui est due au phénomène d'amortissement appelé squeeze film damping en terminologie anglo-saxonne, même sous vide (jusqu'à 0,001 - 0,1 mbar).

Le dispositif d'actionnement peut être de type piézoélectrique, utilisant un empilement de matériaux piézoélectriques. D'une part le dispositif est relativement encombrant vis-à-vis de la structure MEMS ou NEMS à actionner. D'autre part, le procédé de réalisation de l'empilement de matériaux piézoélectriques peut être complexe.

Le dispositif d'actionnement peut être de type magnétique comportant un aimant permanent. Il peut présenter également des problèmes d'encombrement. De plus l'efficacité de ce dispositif diminue fortement avec la taille du MEMS ou du NEMS.

Il existe également un dispositif d'actionnement de type électrothermique. L'actionnement électrothermique utilise les propriétés thermoélastiques des solides pour mettre en mouvement des structures MEMS. En effet, lorsqu'un conducteur électrique est polarisé électriquement, celui-ci dissipe de l'énergie par effet Joule, ce qui engendre un échauffement du conducteur qui se dilate en raison des propriétés thermoélastiques du matériau qui constitue la structure du MEMS ou du NEMS.

Le document Rahafrooz A, Pourkamali S. Thermal-Piezoresistive Energy Pumps in Micromechanical Resonant Structures. IEEE Trans Electron Devices. 2012 Dec;59(12):3587-93 décrit une structure résonante comportant deux éléments suspendus reliés par deux poutres d'actionnement parallèles, les deux poutres d'actionnement étant chacune suspendues au substrat au moyen d'une poutre latérale encastré. La polarisation des deux poutres d'actionnement via les deux poutres encastrées permet un échauffement des poutres d'actionnement et la génération d'un actionnement électrothermique, les poutres se dilatent, les deux éléments suspendus sont alors mis en mouvement l'un par rapport à l'autre. En appliquant une polarisation sinusoïdale, les éléments suspendus sont mis en vibration. Un résonateur haute fréquence peut être réalisé. Le *document* Xiabobo Guo, Yun-bo Yi, Rahafrooz A, Pourkamali, Gas Sensing using thermally actuated dual plate resonators and self-sustained oscillators. Frequency Control Symposium (FCS), 2012 IEEE International. 2012. p. 1-5 décrit un système sensible au gaz environnant comportant deux éléments suspendus reliés par deux poutres d'actionnement parallèles. Chaque élément suspendu est raccordé au substrat par deux poutres sollicitées en flexion.

Le rendement énergétique r entre la poutre d'actionnement et le générateur électrique peut être décrit par

$$ r = \frac{Ppoutre}{P\ tolale} = \frac{Rpoutre}{R\ poutre + R\ accés} $$

Ppoutre est la puissance Joule dissipée au niveau de la ou des poutres d'actionnement, Ptotale est la puissance Joule totale dissipée au niveau de la structure entière, Rpoutre est la résistance électrique de la ou des poutres d'actionnement, et Raccés est la résistance électrique de partie de la structure MEMS entre la source de courant et la ou les poutres d'actionnement, cette résistance comprend notamment les résistances des résistances d'accès présent dans la structure MEMS et à l'extérieur de la structure MEMS, telles que celles des pistes, celles des plots de contact, etc.

Une dissipation d'énergie par effet Joule dans ces résistances d'accès réduit le rendement pour le transfert de la puissance délivrée par un générateur vers la poutre d'actionnement. Si cette dissipation d'énergie est trop importante relativement à celle dans la ou les poutres d'actionnement, le rendement est sensiblement réduit.

Les résistances des poutres d'actionnement sont de l'ordre de quelques ohms du fait des dimensions des structures et du dopage, qui est par exemple de l'ordre de $10 \times 10^{19} \text{cm}^{-3}$. Un courant d'actionnement typique de l'ordre de 10 mA est requis pour produire des échauffements puis des forces d'actionnement usuelles. Au niveau de la poutre d'actionnement, la puissance utile pour l'actionnement est ainsi de l'ordre de quelques centaines de $\mu$W.

Par ailleurs, les sources d'alimentation des électroniques de contrôle (ASIC, FPGA, etc.) présentent des tensions de l'ordre de quelques V : la puissance nécessaire pour produire les courants désirés en l'absence d'étage de conversion de courant - qui sont souvent omis car ils génèrent du bruit ou parce qu'ils sont trop volumineux dans un contexte de miniaturisation - atteint en réalité quelques dizaines de mW, ce qui correspond à des niveaux de puissance élevés pour des systèmes portatifs, tels que des unités autonomes, smartphone, etc. Il en résulte que finalement un faible rendement de transfert de puissance vers la poutre de 1/1000 peut être obtenu. Des niveaux de courant dans la gamme 1-100 mA ne sont pas compatibles avec les exigences usuelles « basse consommation » des capteurs grand public.

Dans la structure décrite dans le document Rahafrooz A, Pourkamali S. Thermal-Piezoresistive Energy Pumps in Micromechanical Resonant Structures. IEEE Trans Electron Devices. 2012 Dec;59(12):3587-93, le courant d'actionnement ressort de la structure par une poutre d'actionnement, ce qui permet de conserver un bon rendement énergétique.

Cependant l'obtention de ce bon rendement limite les choix dans les structures à actionnement électrothermiques réalisables. Notamment, la disposition des éléments mobiles et des poutres d'actionnement impose que les poutres d'actionnement travaillent en phase, sinon les efforts d'actionnement s'opposeraient.

Au-delà du rendement énergétique, on cherche à améliorer le rendement énergétique de transduction, i.e. on cherche à produire une force avec le moins de puissance électrique possible.

Le document US2015/047078 décrit un actionneur pour miroir de microscope AFM, dans lequel le miroir est déplacé au moyen de poutres qui s'allongent sous l'effet d'une élévation de température.

Le document US 6 675 578 décrit un actionneur comportant une partie mobile suspendus par des poutres, qui sont échauffées et se dilatent.

## EXPOSÉ DE L'INVENTION

C'est par conséquent un but de la présente invention d'offrir une structure MEMS et/ou NEMS à actionnement électrothermique offrant un bon rendement énergétique de transduction tout en offrant une grande liberté dans le choix de la configuration de la structure MEMS et/ou NEMS.

Le rendement énergétique de transduction est le rapport entre la force produite et l'énergie totale consommée.

Le but précédemment énoncé est atteint par une structure MEMS et/ou NEMS à actionnement électrothermique comportant une partie fixe, au moins une partie mobile relativement à la partie fixe, une pluralité de poutres d'actionnement connectées à la partie mobile et au moins un élément de liaison électrique entre la partie mobile et la partie fixe, l'épaisseur de la poutre d'actionnement étant inférieure ou égale à la moitié de l'épaisseur de la partie mobile et de l'élément de liaison, les poutres d'actionnement étant des nanofils.

Il résulte de la différence d'épaisseur entre les poutres d'actionnement et l'épaisseur de la partie mobile et l'épaisseur de l'élément de liaison que la résistance électrique dans la poutre est très grande par rapport à celle de la partie mobile et à la résistance de l'élément de liaison, et que la densité de courant est importante dans la poutre d'actionnement et est très faible dans les autres éléments de conduction du MEMS. Les pertes par effet Joule sont ainsi concentrées dans la poutre d'actionnement et l'élévation de température est favorisée dans la poutre d'actionnement. Le rendement de conversion électrique thermique au niveau de la poutre d'actionnement et donc le rendement mécanique sont ainsi améliorés.

Par ailleurs, ce choix d'épaisseur de la poutre d'actionnement permet d'obtenir un bon rendement énergétique sans être limité à des structures particulières.

Par ailleurs, l'utilisation d'une pluralité de nanofils au lieu d'une poutre de section totale équivalente dans un même matériau, permet d'obtenir un échauffement supérieur dans les nanofils avec un même courant total de polarisation. La densité de courant dans les poutres reste identique, comme la puissance dissipée par effet Joule. Il en résulte une force d'actionnement plus grande pour une même puissance consommée. En effet, les nanofils en un matériau donné présentent des conductivités thermiques inférieures à celles du matériau en volume en raison de l'intensification de processus d'interaction de type phonon-phonon ou phonon-surface.

Par ailleurs l'utilisation d'une pluralité de nanofils par rapport à un seul nanofil permet de limiter l'élévation de température tout en offrant un rendement de transduction amélioré. En effet pour une même force d'actionnement la puissance consommée peut certes être identique, mais elle s'accompagne d'une élévation de température dans le nanofil qui pourrait être incompatible avec le bon fonctionnement du système.

En outre, la mise en œuvre de plusieurs poutres permet d'apporter des propriétés mécaniques au MEMS. En effet une section importante peut être nécessaire pour assurer un certain niveau de raideur ou une résistance aux sollicitations mécaniques extérieures (choc, etc.). Cette section important peut être obtenue en sommant les sections des nanofils.

Grâce à l'invention on obtient une structure microélectromécanique et/ou nanoélectromécanique à actionnement électrothermique présentant un rendement énergétique de transduction augmenté.

Le courant délivré pour l'actionnement décroit, par conséquent il en résulte une puissance délivrée par le générateur moindre, ce qui rend la structure MEMS et/ou NEMS compatibles avec des systèmes portables et/ou grand public.

En d'autres termes, le courant électrique d'actionnement circule le long d'un chemin de conduction à travers la structure MEMS et/ou NEMS en passant par la partie fixe, les poutres d'actionnement sous forme de nanofils, la partie mobile, l'élément de liaison et à nouveau la partie fixe. On définit alors dans ce chemin de conduction une zone de forte résistance électrique, relativement à celle de la partie mobile et à celle de l'élément de liaison. Cette zone de forte résistance subit alors un auto-échauffement sensiblement plus important que la partie mobile et l'élément de liaison, cette zone est formée par les poutres d'actionnement. En outre, en mettant en œuvre plusieurs nanofils, on limite l'échauffement qui se répartit entre les différents nanofils et on améliore le rendement de transduction car chaque nanofil offre individuellement des rendements de transduction améliorés. Il en résulte un rendement énergétique de transduction amélioré.

De manière très avantageuse, la ou les poutres d'actionnement ont au moins une dimension transversale inférieure ou égale à 500 nm.

Il en résulte également un faible auto-échauffement de l'élément de liaison, la force générée par auto-échauffement est donc réduite par rapport à celle générée dans la poutre d'actionnement, cette force d'actionnement ne s'oppose pas et/ou ne détériore donc pas l'action d'actionnement de la poutre d'actionnement.

L'élément de liaison peut également présenter une configuration et/ou une disposition par rapport à la poutre d'actionnement, telles que la force générée par effet électrothermique dans l'élément de liaison ne s'oppose pas et/ou ne détériore pas l'action de la poutre d'actionnement.

Dans un mode de réalisation particulièrement avantageux, la structure MEMS et/ou NEMS comporte une partie mobile et au moins deux poutres d'actionnement, au moins un élément de liaison entre la partie mobile et la partie fixe et des moyens pour générer un courant différent dans chaque poutre d'actionnement permettant de générer ainsi des efforts différents. Ce mode de réalisation permet par exemple de réaliser une structure dans laquelle deux poutres d'actionnement situées de part et d'autre de la partie mobile sont alignées et dans laquelle les forces d'actionnement générées dans les poutres d'actionnement sont constructives.

La présente invention a alors pour objet une structure microélectromécanique et/ou nanoélectromécanique à actionnement électrothermique comportant une partie fixe, au moins une partie mobile par rapport à la partie fixe, au moins un ensemble de plusieurs poutres d'actionnement électrothermiques permettant de faire circuler un courant électrique de la partie fixe à la partie mobile et reliées mécaniquement à la partie mobile et aptes à appliquer simultanément une force électrothermique de même sens sur la partie mobile, et au moins un élément de liaison électriquement conducteur reliant électriquement la partie mobile à la partie fixe, dans laquelle l'ensemble de plusieurs poutres d'actionnement électrothermiques présente une épaisseur inférieure ou égale à la moitié d'une épaisseur de la partie mobile et inférieure ou égale à la moitié d'une épaisseur de l'élément de liaison et dans laquelle les poutres d'actionnement sont des nanofils.

De préférence, les poutres d'actionnement électrothermiques comportent un ou plusieurs matériaux thermoélastiques aptes à se déformer sous l'effet d'un échauffement thermique induit par effet Joule par le courant électrique destiné à circuler dans ladite poutre.

Les poutres d'actionnement peuvent-être reliées mécaniquement à la partie fixe et à la partie mobile, ou à deux parties mobiles.

Les poutres d'actionnement électrothermiques présentent avantageusement un rapport de forme compris entre 1 et 2.

L'élément de liaison présente de préférence une forme telle qu'une force électrothermique générée en son sein ne s'oppose pas ou peu à la force électrothermique générée dans la poutre d'actionnement. Avantageusement, l'élément de liaison a la forme d'un ressort replié selon des créneaux ou motifs en grecs. En variante, l'élément de liaison peut présenter toute forme lui offrant une souplesse mécanique dans le plan, et pourrait être formé par un ressort en doubles spirales, chevrons...etc.

Dans un exemple de réalisation, l'élément de liaison s'étend suivant un axe perpendiculaire à un axe auquel la poutre d'actionnement est parallèle. Avantageusement, la structure comporte deux éléments de liaison alignés le long d'un axe perpendiculaire à un axe auquel la poutre d'actionnement est parallèle.

Selon l'invention, les poutres d'actionnement sont des nanofils, car les très faibles dimensions du nanofil permettent d'améliorer la résistivité thermique du matériau réalisant ledit nanofil, ce qui permet d'augmenter l'échauffement thermique du matériau du nanofil pour une puissance électrique donnée. L'épaisseur et/ou la largeur du nanofil est inférieure ou égale à 500 nm.

Dans un exemple de réalisation, la structure peut comporter une articulation en rotation entre la partie fixe et la partie mobile et dans laquelle la poutre d'actionnement est disposée par rapport à la partie mobile de sorte à provoquer sa rotation par rapport à la partie fixe, ladite rotation étant dans le plan de la structure ou hors-plan.

L'articulation en rotation peut comporter l'élément de liaison ou les éléments de liaison alignés définissant l'axe de rotation, le ou lesdits éléments de liaison étant déformables en torsion et dans laquelle la poutre d'actionnement est reliée mécaniquement à la partie mobile de sorte que la force électrothermique générée dans la poutre d'actionnement provoque la rotation hors-plan de la partie mobile.

Dans un autre exemple de réalisation, l'articulation en rotation peut comporter deux éléments de liaison dont les axes sont sécants.

Dans un autre exemple de réalisation, la partie mobile est reliée mécaniquement à la partie fixe par un ancrage, ledit ancrage formant un élément de liaison, la poutre d'actionnement étant orientée par rapport à la partie mobile pour provoquer sa déformation élastique.

De préférence, l'épaisseur de la partie mobile et l'épaisseur de l'élément de liaison sont égales.

La structure peut comporter en outre des moyens de détection d'un déplacement de la partie mobile. Les moyens de détection sont avantageusement des moyens piézorésistifs. En variante, les moyens de détection pourraient être des moyens piézoélectriques ou tout autre moyen adapté. Avantageusement, les moyens de détection sont formés par la poutre d'actionnement.

La présente invention a également pour objet un actionneur comportant au moins une structure selon l'invention.

La présente invention a également pour objet un capteur comportant au moins une structure selon l'invention.

## BRÈVE DESCRIPTION DES DESSINS

La présente invention sera mieux comprise sur la base de la description qui va suivre et des dessins en annexe sur lesquels:

- la figure 1A est un vue de dessus un exemple de réalisation d'une structures MEMS et/ou NEMS à mouvement dans le plan,
- la figure 1B est une vue en coupe longitudinale selon le plan 1-1 de la structure de la figure 1A,
- la figure 2 est une vue de dessus d'un autre exemple de réalisation d'une structure MEMS et/ou NEMS mettant en œuvre des nanofils,
- les figures 3A et 3B sont des vues en coupe longitudinale de deux structures MEMS et/ou NEMS selon deux variantes de réalisation, dans lesquels la poutre d'actionnement est à différentes positions,
- la figure 4A est une vue de dessus d'un autre exemple de réalisation d'une structure MEMS et/ou NEMS,
- la figure 4B est une vue de dessus d'une variante de la structure de la figure 4A,
- la figure 5A est une vue de dessus d'un exemple de réalisation d'une structure MEMS et/ou NEMS à mouvement de rotation hors-plan,
- la figure 5B est une vue en coupe longitudinale de la structure de la figure 5A le long d'un plan II-II en cours d'actionnement,
- la figure 6 est une vue de dessus d'un exemple de réalisation d'une structure MEMS et/ou NEMS à mouvement de rotation dans le plan,
- la figure 7 est une vue de dessus d'un exemple de réalisation d'une structure MEMS et/ou NEMS comportant deux poutres d'actionnement activées chacune par une source de courant différente,
- la figure 8 est une vue de dessus d'un autre exemple de réalisation d'une structure MEMS et/ou NEMS à deux poutres d'actionnement activées chacune par une source de courant différente,
- les figures 9A et 9B sont des vues de dessus de deux structures MEMS et/ou NEMS selon un autre exemple de réalisation dans lequel la partie mobile est déformée en flexion,
- la figure 9C est une vue de côté d'une structure similaire à celle des figures 5A et 5B mettant en œuvre deux poutres d'actionnement pouvant être activées séparément,
- la figure 10 est une vue de dessus d'un autre exemple de réalisation d'une structure MEMS et/ou NEMS à deux poutres d'actionnement activées chacune par une source de courant différente,
- la figure 11 est une vue de dessus d'un exemple de réalisation d'une structure MEMS et/ou NEMS à quatre poutres d'actionnement activées chacune par une source de courant différente,
- la figure 12 est une représentation schématique d'une structure MEMS et/ou NEMS comportant des moyens de modification de l'intensité de la force appliquée à la partie mobile par une poutre d'actionnement électrothermique,
- la figure 13 est une vue de dessus d'un exemple de réalisation d'une structure MEMS et/ou NEMS à deux poutres d'actionnement activées chacune par une source de courant différente, particulièrement adaptée à une compensation du flux thermique,
- la figure 14 est une représentation du schéma thermique de la structure de la figure 13,
- la figure 15 est une vue de dessus d'une variante de la structure de la figure 13 comportant des moyens de détection de déplacement de la partie mobile,
- la figure 16 est une représentation schématique d'une structure vue de dessus à une poutre d'actionnement reliant deux parties mobiles.

## EXPOSÉ DÉTAILLÉ DE MODES DE RÉALISATION PARTICULIERS

La description qui va suivre va décrire des structures MEMS et/ou NEMS à actionnement électrothermique, ces structures pouvant être mises en œuvre dans un grand nombre d'applications, telles que les actionneurs pour déplacer un miroir ou un interrupteur et les capteurs.

Dans la présente demande, on entend par « partie mobile » une partie d'une structure MEMS et/ou NEMS apte à se déplacer au moins partiellement par rapport à une partie fixe ou substrat de la structure MEMS et/ou NEMS dans le plan de la structure ou hors-plan de la structure. On entend par déplacement « au moins partiellement », une partie qui serait par exemple ancrée par une extrémité sur la partie fixe et dont une autre extrémité serait déformée mécaniquement et de manière élastique.

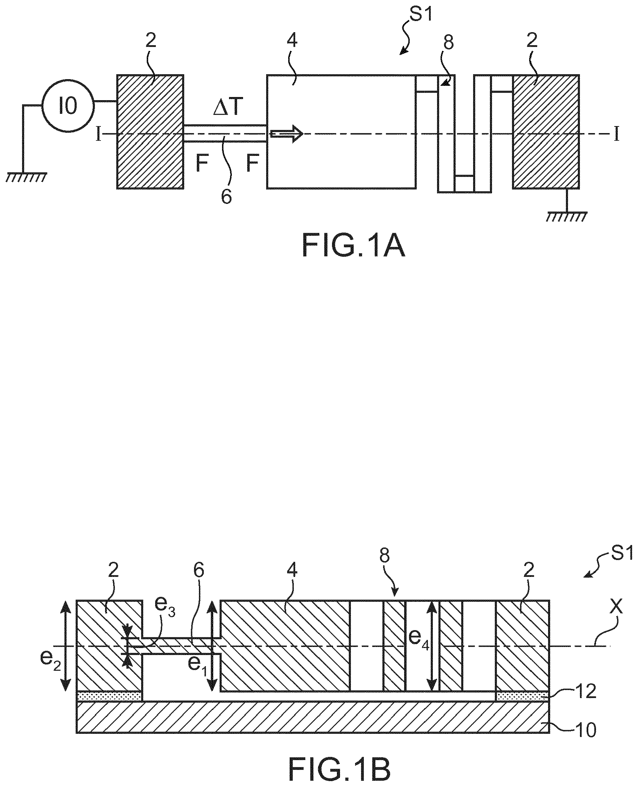

Sur les figures 1A et 1B, on peut voir un exemple de réalisation d'une structure MEMS et/ou NEMS S1 à actionnement électrothermique dans le plan, comportant une partie fixe 2, une partie suspendue 4 par rapport à la partie fixe et destinée à être déplacée par rapport à la partie fixe 2, une poutre d'actionnement 6 reliant la partie fixe et la partie mobile 4 et un élément de liaison 8 également entre la partie fixe 2 et la partie mobile 4.

Dans l'exemple représenté, la poutre d'actionnement s'étend le long d'un axe X qui est la direction de déplacement de la partie mobile 4 par rapport à la partie fixe. La partie fixe a un degré de liberté en déplacement le long de l'axe X.

La poutre d'actionnement électrothermique 6 comporte avantageusement un ou plusieurs matériaux thermoélastiques aptes à se déformer sous l'effet d'un échauffement thermique induit par effet Joule par le courant électrique destiné à circuler dans ladite poutre. Le ou les matériaux est ou sont choisis parmi le silicium, le SiC, le SiN par exemple. Si le matériau n'est pas conducteur électrique, la conduction électrique et l'effet Joule peuvent être assurés par un matériau conducteur déposé sur la poutre (Si, Al, etc.)

L'élément de liaison 8 se raccorde à la partie mobile sur une face opposée à celle à laquelle se raccorde la poutre d'actionnement 6. L'élément de liaison 8 a avantageusement une forme de ressort en créneau de sorte à présenter une certaine souplesse dans la direction de l'axe X. En outre cette forme permet avantageusement de réduire la force électrothermique apparaissant dans l'élément de liaison et qui sera décrite ci-dessous. L'élément de liaison peut présenter une autre forme, telle qu'une forme de ressort en double spirale ou en chevron.

La partie fixe 2, la partie mobile 4, la poutre d'actionnement 6 et l'élément de liaison 8 sont réalisés dans un ou des matériaux conducteurs électriques.

L'élément de liaison remplit également de manière avantageuse la fonction d'élément de suspension. Il offre en outre une raideur hors-plan importante de la structure d'autant plus, comme cela sera décrit par la suite, que l'élément de suspension présente une épaisseur importante par rapport à celle de la poutre d'actionnement qui offre une raideur hors-plan moindre.

La partie fixe 2 est solidaire d'un substrat 10 qui s'étend sous toute la structure MEMS et/ou NEMS et est isolé électriquement de celui-ci par une couche isolante électrique 12. L'épaisseur de la partie fixe 2 qui est conductrice électrique est égale à e2. La partie mobile présente une épaisseur e1. Dans cet exemple et de manière préférée, du fait du procédé de réalisation la partie fixe 2 et la partie mobile 4 sont issues de la même couche en matériau conducteur électrique, par exemple en un matériau semi-conducteur. Il en résulte que e1 = e2.

L'épaisseur de la poutre d'actionnement est désignée e3 et l'épaisseur de l'élément de liaison est désignée e4.

L'épaisseur e3 de la poutre d'actionnement 6 est inférieure ou égale à la moitié de l'épaisseur de la partie mobile et inférieure ou égale à la moitié de l'épaisseur de l'élément de liaison i.e. e3 $\leq$ e2/2 et e3 $\leq$ e4/2.

De préférence, la largeur de la poutre d'actionnement est choisie de sorte à avoir un rapport de forme compris entre 1 et 2.

La poutre a par exemple une section de 250 nm $\times$ 250 nm et la longueur de la poutre d'actionnement est par exemple comprise entre 100 nm et 100 $\mu$m. e3 est par exemple compris entre 10 nm et 100 $\mu$m, de préférence entre 10 nm et 50 nm, et e1 et e2 sont par exemple compris entre 20 nm et 100 $\mu$m.

La ou les poutre(s) d'actionnement peut ou peuvent être réalisée(s) avec des matériaux adaptés à la réalisation de structure MEMS et/ou NEMS. La force d'actionnement générée par une poutre dépend du produit du coefficient de dilatation $\alpha$ et du module d'Young E. Ce produit est de préférence maximisé.

Par exemple, pour du silicium : $\alpha$ = 2,6 *ppm/K* et *E* = 169 *GPa,* pour du nitrure de silicium: $\alpha$ = 3.26 *ppm/K* et *E* = 1125 *GPa* et pour du carbure de silicium: $\alpha$ = 4 *ppm/K* et *E* = 450 *GPa.* Le carbure de silicium est particulièrement avantageux.

La structure MEMS et/ou NEMS est destinée à être reliée à une source de courant électrique ou une source de tension désignée par $I_0$ par exemple par des plots de contact réalisés sur la partie fixe de part et d'autre de la partie mobile. Cette source S peut être alternative ou continue.

Dans la suite de la description et à des fins de simplicité, nous considérons uniquement une source de courant électrique qui sera désignée « source de courant ».

Le fonctionnement de la structure S1 va maintenant être décrit.

Un courant $I_0$ est appliqué à la structure S1, celui-ci traverse la poutre d'actionnement 6, circule dans la partie mobile 4 et traverse l'élément de liaison 8, ce qui provoque principalement l'échauffement par effet Joule de la poutre d'actionnement 6. Il y a alors apparition au sein de la poutre d'actionnement 6 d'une contrainte mécanique au niveau des ancrages par une force répulsive qui s'exerce sur eux. Cette force est en générale dirigée selon l'axe principal de la poutre. Il en résulte une extension de la poutre d'actionnement par effet thermoélastique. La poutre d'actionnement 6 étant reliée à la partie mobile 4 qui est libre de se déplacer le long de l'axe X et l'élément de liaison 8 présentant une grande souplesse selon la direction X, il y a alors un déplacement de la partie mobile 4 le long de l'axe X en direction de l'élément de liaison 8.

Du fait de l'épaisseur de la poutre d'actionnement très inférieure à celles de la partie mobile, la résistance de la poutre est supérieure à celle de la partie mobile qui permet l'accès du courant à la poutre d'actionnement.

Il y a une concentration de la densité de courant dans la poutre d'actionnement, ce qui favorise une élévation de température plus importante dans celle-ci en comparaison des parties fixe et mobile. La puissance fournie sert principalement à échauffer la poutre et donc à générer une force par effet électrothermique. Cette force est d'autant plus grande que l'échauffement est grand. On obtient alors un meilleur rendement énergétique.

Si le courant est un courant alternatif, la partie mobile est mise en vibration. La fréquence de vibration peut être d'autant plus élevée que la constante de temps thermique de la poutre d'actionnement est faible, ceci est notamment le cas lorsqu'elle présente de faibles dimensions. De préférence la longueur est comprise entre 100 nm et 20 $\mu$m.

L'épaisseur de la partie fixe n'est pas prise en compte, car celle-ci présente une très grande surface par rapport à celle de la partie mobile et de l'élément de liaison, par conséquent sa résistance est typiquement très inférieure à celles de la partie mobile et de l'élément de liaison. En outre, des contraintes de dimensionnement imposées par le cahier des charges du MEMS s'appliquent à la partie mobile. Pour l'élément de liaison, il n'est pas ou difficilement envisageable qu'il présente une grande largeur, sinon il pourrait perturber le fonctionnement mécanique de la structure.

A titre d'exemple, considérons une structure MEMS et/ou NEMS dans laquelle la poutre d'actionnement a une épaisseur de 0,25 $\mu$m, une largeur de 0,25 $\mu$m et une longueur 5 $\mu$m et dans laquelle l'élément de liaison a une épaisseur de 1 $\mu$m, une largeur de 2 $\mu$m et une longueur de 50 $\mu$m. Considérons en outre que la résistance d'accès est principalement celle de l'élément de liaison. De plus la poutre d'actionnement et l'élément de liaison sont réalisés dans le même matériau.

$$\text{Le rendement } r = \frac{Ppoutre}{P\ tolale} = \frac{Rpoutre}{R\ poutre + Raccés} = 96\%$$

La mise en œuvre d'une poutre d'actionnement présentant une épaisseur faible, permet avantageusement d'atteindre des résistances de poutres de plusieurs milliers d'Ohm. De telles résistances permettent d'atteindre des courants d'actionnement dans la gamme 100 $\mu$A - 1mA avec l'aide d'un générateur de l'ordre de 1V. Le courant délivré par le générateur est proche ou dans la gamme de courant visé. Dans ces conditions, la majeure partie de la puissance délivrée par un générateur de 1V est transmise à la poutre d'actionnement sans avoir recours à des convertisseurs DC-DC.

Par exemple, pour une poutre d'actionnement ayant les dimensions 0,25 $\mu$m x 0,25 $\mu$m x 5 $\mu$m, la résistance électrique R de la poutre d'actionnement est de :

R = 4100 $\Omega$ avec un dopage $2\times10^{19}$ cm$^{-3}$.
R = 1860 $\Omega$ avec un dopage $5\times10^{19}$ cm$^{-3}$.

L'élément de liaison 8 est également traversé par le courant, il assure la fermeture du circuit électrique. L'élément de liaison 8 subit également un auto-échauffement mais du fait de sa configuration en ressort, les différentes branches perpendiculaires à l'axe X peuvent se dilater librement et la force exercée par l'élément de liaison 8 sur la partie mobile 4 est négligeable par rapport à celle exercée par la poutre d'actionnement 6. Par ailleurs, en choisissant un élément de liaison dont la raideur est faible dans la direction X par rapport à la raideur de la structure MEMS et/ou NEMS, la déformation thermoélastique a principalement lieu sur l'élément de liaison 8. Une force d'actionnement très faible s'exerce alors sur la partie mobile 4.

L'élément de liaison 8 présentant une épaisseur très supérieure à celle de la poutre d'actionnement, elle présente également une résistance électrique faible, son auto-échauffement est réduit par rapport à la poutre. La force électrothermique résultante peut par exemple être au moins d'un ordre de grandeur plus bas que celle générée dans la poutre d'actionnement. De préférence, la résistance électrique du ou des éléments de suspension est au moins cinq fois plus faible que celle de la ou des poutres d'actionnement. En combinant la faible résistance électrique de l'élément de liaison et la faible raideur de l'élément de liaison, l'effet de l'élément de liaison sur la partie mobile du fait des forces générées par effet électrothermique dans l'élément de liaison est très faible.

En variante, le matériau de l'élément de liaison pourrait être dopé pour présenter une meilleure conductivité électrique et thermique que celle du matériau de la poutre d'actionnement ou être réalisé dans un matériau présentant un coefficient de dilatation plus faible que celui du matériau de la poutre d'actionnement.

On peut prévoir, par exemple dans une application à un capteur, des moyens de détection des mouvements de la partie mobile générés par la force électrothermique. La ou les poutres d'actionnement peuvent être réalisées en matériau piézorésistif formant les moyens de détection. La variation de résistance électrique des poutres permet de connaître le mouvement de la partie mobile. En variante, il pourrait s'agit d'un matériau piézoélectrique.

La structure S1 peut comporter plusieurs poutres d'actionnement 6 parallèles disposées côte à côte.

De préférence, la ou les poutres d'actionnement ont une longueur supérieure ou égale à au moins 10 fois leur dimension transverse la plus grande. Le rapport entre la longueur et la dimension transverse la plus grande est avantageusement compris entre 5 et 200. Il est à noter que plus la longueur de la poutre d'actionnement est importante plus la gamme de fonctionnement de la poutre d'actionnement diminue du fait du phénomène de flambage.

Dans le dimensionnement de la ou des poutres d'actionnement la limite de flambage est prise en compte. La limite de flambage décroit en L$^2$ : Par exemple, pour une poutre de 12μm de long, la contrainte maximale autorisée en compression est de 300 MPa pour une section de 250 nm x 250 nm. Dans ce cas précis, le rapport L/t atteint 48. Les contraintes recherchées pour réaliser de l'actionnement peuvent atteindre plusieurs centaines de MPa pour les valeurs les plus fortes.

Des poutres d'actionnement longues offrent de meilleures performances.

En effet, une ou des poutres d'actionnement longue(s) présente(nt) une plus grande résistance électrique. Le rendement global de la puissance Joule peut alors être amélioré et les courants nécessaires peuvent être plus faibles ce qui est favorable, ce qui permet de réduire la puissance fournie par la source de courant pour de mêmes performances.

Une ou des poutres d'actionnement longue(s) offre une plus grande isolation thermique ce qui permet d'augmenter l'effet d'auto échauffement lors du passage d'un courant électrique à puissance électrique constante, ou de diminuer la consommation électrique à force électrothermique constante.

De manière particulièrement avantageuse, la ou les poutres d'actionnement est ou sont formée(s) par un nanofil dont la largeur et/ou l'épaisseur est ou sont inférieure(s) ou égale(s) à 500 nm.

En effet, à de telles dimensions, le nanofil présente des conductivités thermiques inférieures à celles du matériau en volume en raison de l'intensification de processus d'interaction de type phonon-phonon ou phonon-surface. Par exemple, dans le cas du silicium, une réduction d'un facteur 3 peut être observée pour des nanofils de section 250 nm x 250 nm, les nanofils présentent une conductivité thermique de 50 W/m/K alors que le silicium massif présente une conductivité thermique de 140 W/m/K.

Le profil de température T(x) au sein d'une poutre de longueur L traversée par un courant de densité j peut être approché par :

$$T = T_0 + \frac{\rho j^2}{2\kappa} x(L - x)$$

$\rho$ est la résistivité, $\kappa$ la conductivité thermique. La température maximale est atteinte au milieu de la poutre :

$$\Delta T_{max} = \frac{\rho j^2}{8\kappa} L^2$$

L'amplitude d'auto-échauffement étant inversement proportionnelle à la conductivité thermique, un nanofil de section nanométrique, par exemple dont la largeur et/ou l'épaisseur est ou sont comprise(s) entre 10 nm et 500 nm, bénéficie ainsi d'un échauffement amplifié et donc d'une force d'actionnement amplifiée par unité de surface (section de la poutre), par rapport à une poutre d'actionnement de dimensions supérieures.

Des poutres d'actionnement sous la forme de micropoutres de quelques μm de dimensions transversales et de longueur par exemple entre 5 μm à 10 μm présentent l'avantage d'avoir une inertie thermique réduite par rapport à des poutres d'actionnement de microsystèmes de l'état de la technique, les temps de réponse dans la génération de la force sont alors plus courts lors d'une sollicitation électrique. De telles poutres d'actionnement permettent de réaliser des structures MEMS et/ou NEMS avec des fréquences de résonance élevées, par exemple dans la gamme de fréquence 1MHz et 1GHz.

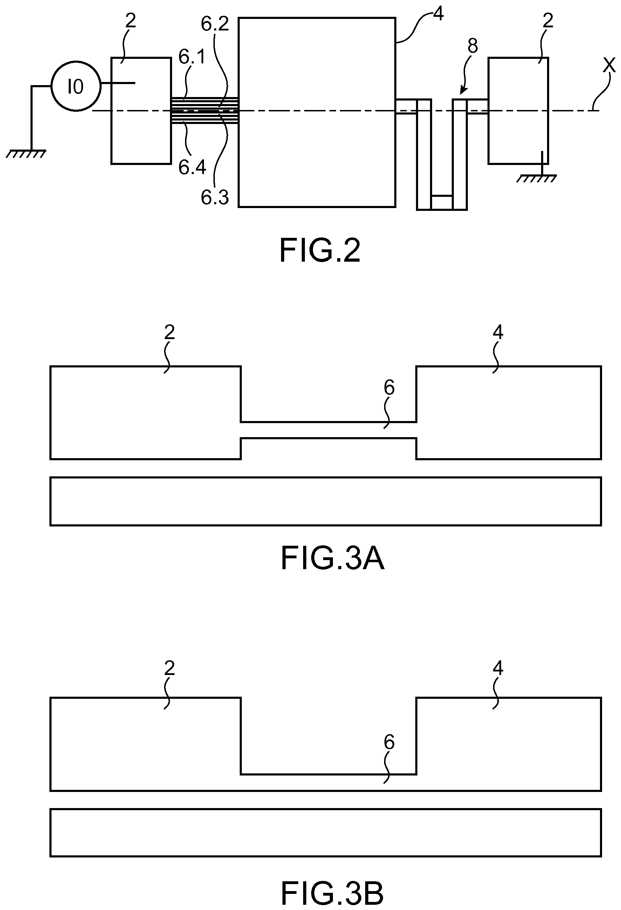

Sur la figure 2, on peut voir une structure MEMS et/ou NEMS comportant plusieurs poutres d'actionnement 6.1, 6.2, 6.3, 6.4 sous forme de nanofils disposées parallèlement les uns à côté des autres.

La configuration dans laquelle plusieurs nanofils représentent au total la même section qu'une poutre d'actionnement unique est particulièrement avantageuse, car à section totale constante, la puissance électrique consommée est identique à celle consommée par une poutre d'actionnement unique, la raideur mécanique exercée sur les structures aux extrémités du nanofil est équivalente, mais du fait de l'amplification décrite ci-dessus, la force totale exercée par les nanofils est amplifiée par rapport à celle appliquée par une poutre d'actionnement unique.

Cette structure présente alors un rendement énergétique amélioré.

Si on considère n nanofils remplaçant une poutre, présentant la même section et la même longueur, on a pour le nanofil i: : $R_i = nR_p$ avec $R_p$ la résistance de la poutre.

La puissance dans un nanofil s'écrit alors $P_i = R_i \times \left(\frac{I}{n}\right)^2 = \frac{R_p I^2}{n}$, soit la puissance totale dans les n nanofils $= \sum_i^N P_i = R_p I^2$, soit la puissance consommée par la poutre de section totale équivalente.

La raideur d'un nanofil $k_i = \frac{k_p}{n}$, avec $k_p$ la raideur de la poutre, soit une raideur longitudinale équivalente $k$

$= k_p$ identique à la raideur de la poutre de section totale équivalente.

La constante de temps pour chaque nanofil s'écrit $\tau_i = R_{th,i} C_i = R_{th} C$ dans le cas ou les paramètres matériaux sont inchangés.

Avec

$$R_{th} = \frac{L}{S\kappa}$$

$$C = cLS$$

$$R_{thi} = \frac{nL}{S\kappa_i}$$

$$C_i = \frac{cLS}{n}$$

c est la capacité thermique par unité de volume, C la capacité thermique de la poutre d'actionnement, $C_i$ la capacité thermique d'un nanofil, $\kappa$ la conductivité thermique de la poutre d'actionnement, $\kappa_i$ est la conductivité thermique du nanofil, S la section de la poutre d'actionnement et S/n la section d'un nanofil, L la longueur de la poutre d'actionnement et d'un nanofil. En pratique, la constante de temps ou temps de réponse augmente légèrement puisque la conductivité thermique diminue. On peut compenser au moins en partie cette augmentation en réduisant longueur du nanofil. Le temps de réponse d'un nanofil peut être supérieur à celui d'un nanofil plus épais du fait de la diminution de la conductivité thermique.

Les nanofils peuvent par exemple être réalisés par des techniques de gravure planaires qui permettent d'atteindre des largeurs de poutres de l'ordre de 100 nm en utilisant la méthode de gravure ultraviolet profond (Deep Ultra Violet en terminologie anglo-saxonne) ou de 5 nm en utilisant la méthode de gravure par rayon électronique (« e-beam lithography » en terminologie anglo-saxonne), tout en conservant des dimensions identiques pour le reste des structures MEMS/NEMS.

L'épaisseur des nanofils peut être obtenue en mettant en œuvre une couche structurelle plus mince que celle utilisée pour le reste de la structure MEMS. Un tel procédé de réalisation mettant en œuvre deux couches structurelles est bien connu de l'homme du métier.

La structure selon l'invention permet d'avoir une poutre ou des poutres d'actionnement de taille réduite en comparaison de la partie mobile qu'elle(s) met ou mettent en mouvement tout en conservant une bonne efficacité d'actionnement. Par exemple, le rapport entre les surfaces des structures planaires du MEMS (ces surfaces incluent celle de la partie mobile et des pistes fixes utilisées pour la polarisation) et de la poutre peut atteindre typiquement des facteurs 1000-10000. En termes de volume, le rapport peut être compris entre 10000 et 100000.

Dans l'exemple représenté sur la figure 1B, la poutre d'actionnement 6 est située sensiblement dans le plan médian de la partie mobile 4. Cette disposition n'est pas limitative. Sur la figure 3A, la poutre d'actionnement 6 est située au-dessous du plan médian dans la partie mobile 4. Sur la figure 3B, la poutre d'actionnement 6 est située au-dessus du plan médian, sa face supérieure étant dans le plan de la face supérieure de la partie mobile 4. Ces configurations ne sont pas limitatives et toute autre configuration est envisageable.

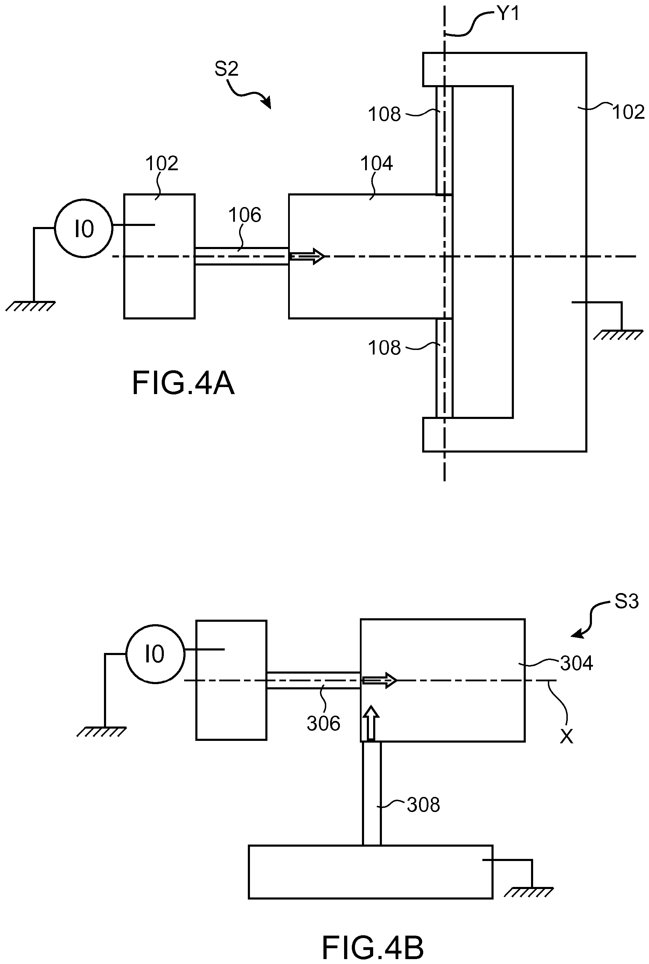

Sur la figure 4A, on peut voir un autre exemple de réalisation d'une structure MEMS et/ou NEMS S2. La structure S2 diffère de la structure S1 en ce qu'elle comporte deux éléments de liaisons 108 formés par des poutres et s'étendant perpendiculairement à l'axe de la poutre d'actionnement de part et d'autre de la partie mobile. Les éléments de liaisons 108 sont alignés le long d'un axe Y1. Dans l'exemple représenté, les éléments de liaison 108 sont situés au niveau des extrémités longitudinales des bords de la partie mobile 104 parallèles à l'axe X, du côté opposé de la partie mobile 104 à celui auquel est raccordée la poutre d'actionnement 106. Dans cette exemple, une partie de la partie fixe 102 est conformée en U pour permettre aux éléments de liaison de se raccorder à la partie fixe 102.

L'actionnement de cette structure S2 est similaire à celui de la structure S1 sauf que le courant circule dans les deux éléments de liaison 108. Les deux éléments de liaison 106 sont échauffés et une force électrothermique apparaît dans chacun deux. Mais du fait de leur position en regard le long de l'axe YI, les forces électrothermiques dans les éléments de liaison 108 se compensent. La force électrothermique apparaissant dans la poutre d'actionnement selon l'axe X assure un déplacement de la partie mobile le long de l'axe X. le dimensionnement des éléments de liaison 108 est tel que ceux-ci fléchissent dans le plan sous l'effet de la force électrostatique. L'actionnement de la partie mobile 6 n'est donc pas perturbé par l'auto-échauffement des éléments de liaison.

La détection de mouvement de la partie mobile peut être réalisée en utilisant les éléments de liaison de la structure S2 réalisés par exemple en matériau piézorésistif.

Sur la figure 4B, on peut voir un autre exemple de réalisation d'une structure MEMS et/ou NEMS S3 comportant un seul bras de liaison 308 d'axe perpendiculaire à l'axe X. Dans l'exemple représenté, il se situe au niveau de l'extrémité longitudinale d'un bord de la partie mobile 304 parallèle à l'axe X du côté de la poutre d'actionnement 306.

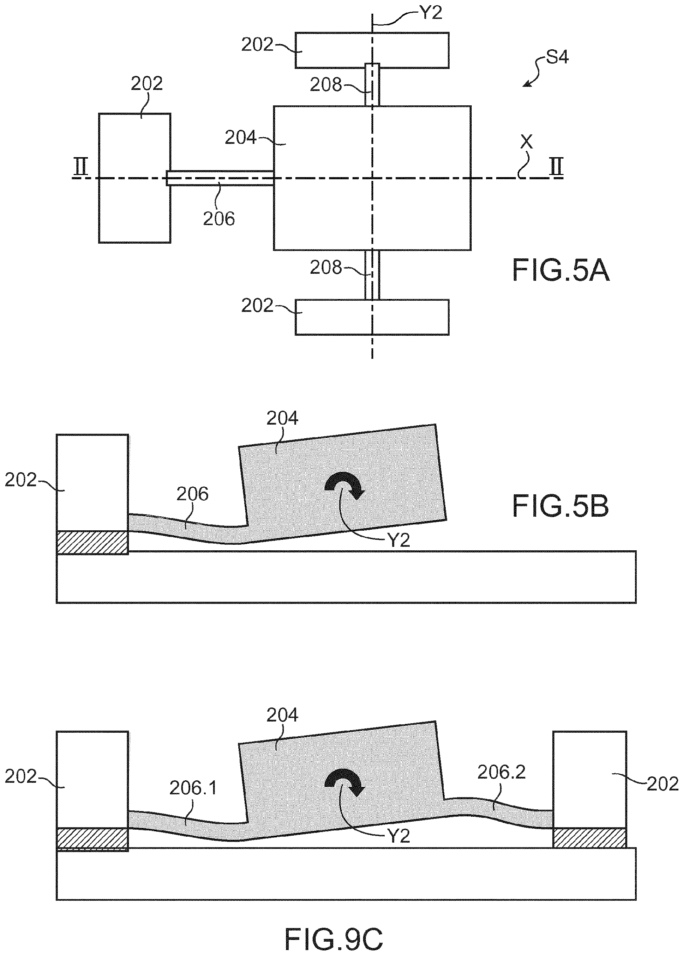

Les figures 5A, 6 et 7 montrent des structures comportant une poutre d'actionnement apte à appliquer une force électrothermique dans un sens, mais ces structures peuvent être mises en œuvre dans le cadre de l'invention mettant en œuvre un ensemble de plusieurs poutres d'actionnement.

Sur les figures 5A et 5B, on peut voir un autre exemple d'une structure S4 permettant un déplacement hors-plan. La structure S4 comporte deux éléments de liaison 208 formés par des poutres et s'étendant perpendiculairement à l'axe de la poutre d'actionnement 206 de part et d'autre de la partie mobile 204. Dans l'exemple représenté, les éléments de liaisons 208 sont alignés le long d'un axe Y2 et sont situés sensiblement au milieu des côtés de la partie mobile 204 parallèles à l'axe X. En outre, la poutre d'actionnement 206 comporte une face inférieure dans le même plan que la face de la partie mobile en regard du substrat. Par ailleurs, l'axe Y2 et la poutre d'actionnement 206 sont dans des plans différents, par exemple les éléments de liaison 208 sont situés dans le plan médian de la partie mobile 204. L'axe de rotation se situe approximativement dans le plan médian des éléments 208.

Les bras de liaison 208 sont réalisés de sorte à présenter une raideur suffisante à la flexion et être déformables en torsion afin de former un axe de rotation pour la partie mobile comme on peut le voir sur la figure 5B. En effet la force électrothermique qui apparait au sein de la poutre d'actionnement 206, s'exerce sur la partie mobile 204 qui est fixée à la partie fixe 202 par les éléments de liaison 208, qui se déforment en torsion autour de l'axe Y2. La partie mobile 204 pivote alors autour de l'axe X.

Dans cet exemple de réalisation, la partie mobile 204 ne peut pivoter que dans le sens antihoraire à partir de sa position repos.

La poutre d'actionnement peut être située dans toute position par rapport à la partie mobile différente du plan contenant l'axe de rotation, i.e. l'axe Y2 des bras de liaison 206.

Cette structure à actionnement hors-plan est particulièrement avantageuse car l'actionnement hors plan est difficile à réaliser avec les structures de l'état de la technique, par exemple avec un actionnement de type capacitif. En effet dans un structure comportant des électrodes capacitives de type peignes interdigités, le moment mécanique au niveau d'un axe de rotation situé au niveau du plan médian de la structure MEMS est nul. Il faut alors ajouter des électrodes planaires localisées au-dessus ou en dessous du MEMS, ce qui complexifie la fabrication.

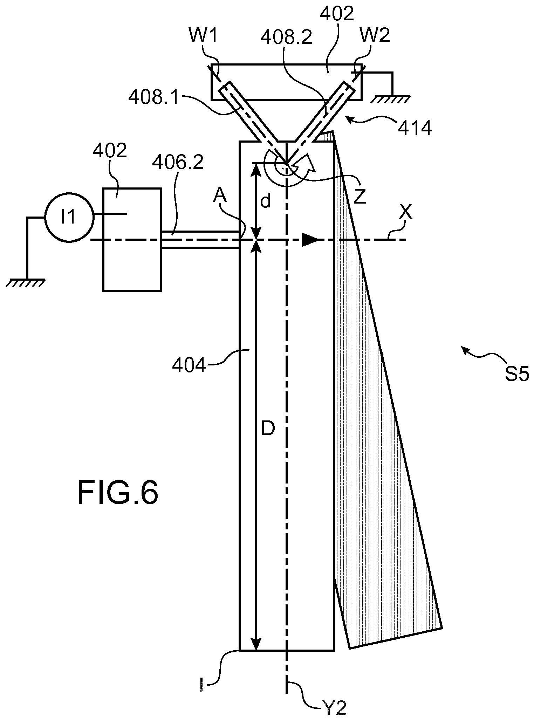

Sur la figure 6, on peut voir un autre exemple de réalisation d'une structure S5 dans lequel la partie mobile est articulée en rotation dans le plan.

La structure S5 comporte une partie fixe 402, une partie mobile 404, des moyens d'articulation ou charnière 414 en rotation de la partie mobile 404 par rapport à la partie fixe, et une poutre d'actionnement 406 entre la partie fixe et la partie mobile.

La charnière comporte un axe de rotation Z perpendiculaire au plan de la structure et deux bras formant deux éléments de liaison 408.1, 408.2. Les deux éléments de liaison 408.1, 408.2 sont connectés à la partie fixe 402 et à la partie mobile 404 et sont inclinés l'un par rapport à l'autre de sorte que leurs axes W1, W2 soient sécants au niveau de la partie mobile 404, les axes W1 et W2 étant sécants en Z. A titre d'exemple non limitatif, l'angle entre les axes W1 et W2 peut par exemple être égal à 90°.

L'axe X de la poutre d'actionnement et l'axe de rotation Z ne sont pas sécants, de sorte qu'une force électrothermique appliquée le long de l'axe X provoque une rotation de la partie mobile autour de l'axe Z. La partie mobile 404 se déplace dans le sens antihoraire sous l'effet de la force, la partie mobile prend alors la position représentée en pointillés et dans le sens horaire lorsque la force cesse.

L'épaisseur de la poutre d'actionnement 406 est inférieure ou égale à la moitié de l'épaisseur de la partie mobile 404 et de l'épaisseur des éléments de liaison 408.1, 408.2.

Un auto-échauffement de la poutre d'actionnement 406 provoque donc une rotation de la partie mobile 404 autour de l'axe Z.

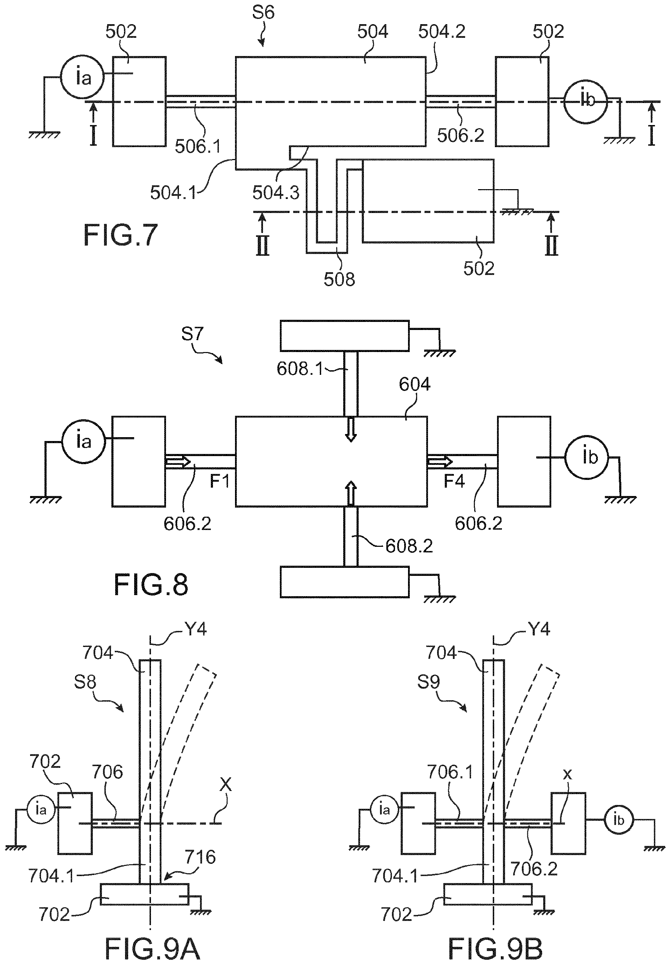

De préférence et comme cela est représenté sur la figure 7, la structure S6 permet d'amplifier l'amplitude de déplacement d'un point I situé sur la partie mobile à l'opposé de l'axe Z par rapport à l'axe X de la poutre.

En effet, si on considère la distance d, entre le point d'intersection entre l'axe X et un axe Y2 formant l'axe longitudinal de la partie mobile 404 et le point d'intersection de Z et Y2, et la distance D entre et le point d'intersection de Z et Y2 et le point I, l'amplitude de déplacement du point I est amplifiée par rapport à celle du point d'intersection entre l'axe X et l'axe Y2 d'un rapport D/d.

Des rapports de l'ordre de 10 à 200 peuvent être aisément obtenus. Des amplitudes de l'ordre de la dizaine de nanomètres au niveau de la poutre d'actionnement peuvent provoquer des déplacements du point I sur plus d'1$\mu$m.

Une telle structure peut par exemple être mise en œuvre pour mettre en mouvement les masses inertielles d'un gyromètre pour lequel les amplitudes de vibration peuvent atteindre plus d'1$\mu$m.

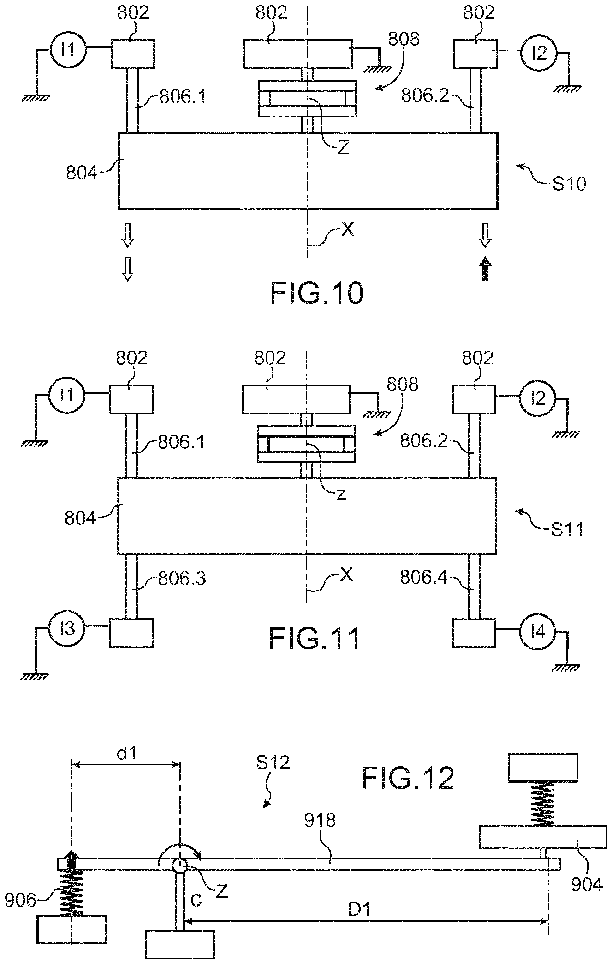

Sur la figure 12, on peut voir un autre exemple de réalisation d'une structure S13 représentée schématiquement permettant une adaptation de la force appliquée à la partie mobile de la structure et une amplification de l'amplitude de déplacement de la poutre d'actionnement.

La structure S13 met en œuvre un bras de levier 918 articulé autour d'un axe Z perpendiculaire plan de la structure. Une poutre d'actionnement 906 est disposée d'un côté de l'axe de rotation et d'un côté du bras de levier et la partie mobile 904 est disposée de l'autre côté du bras de levier et de l'autre côté de l'axe de rotation.

En désignant par d1, la distance entre l'axe de rotation et le point d'application de la force électrothermique Fp sur le bras de levier et Dl la distance entre l'axe de rotation et le point d'application de la force Fm du bras de levier sur la partie mobile 904.

$$Fm = d1/D1 \times Fp.$$

Il est possible de réduire l'intensité de la force appliquée à la partie mobile.

Cette structure S13 permet d'avoir un déplacement appliqué à la partie mobile amplifié par rapport à celui de la poutre d'actionnement d'un rapport D1/d1.

En variante, l'axe de rotation du bras de levier peut être parallèle au plan de la structure, par exemple en réalisant un axe de rotation déformable en torsion.

Sur la figure 7, on peut voir un autre exemple de réalisation d'une structure S6 particulièrement avantageux permettant d'appliquer au moins deux forces électrothermiques différentes.

Dans l'exemple représenté, la structure S6 comporte une partie fixe 502, une partie mobile 504, une première poutre d'actionnement 506.1 s'étendant entre la partie fixe et un bord 504.1 de la partie mobile 504, une deuxième poutre d'actionnement s'étendant entre la partie fixe et un bord 504.2 de la partie mobile 504 opposé au bord 504.1, et au moins un élément de liaison 508 entre la partie mobile 504 et la partie fixe 502. L'élément de liaison 508 dans l'exemple représenté s'étend en un bord 504.3 de la partie mobile perpendiculaire aux bords 504.1 et 604.2. Il a entre outre la forme d'un ressort en forme de créneaux. En variante les poutres d'actionnement pourraient être raccordées à deux côtés consécutifs de la partie mobile ou au même côté et l'élément de liaison pourrait se raccorder à tout côté de la partie mobile.

Les poutres d'actionnement ont une épaisseur inférieure ou égale à la moitié de l'épaisseur de la partie mobile et de l'épaisseur de l'élément de liaison.

Chaque poutre d'actionnement 506.1, 506.2 est destinée à être traversée par un courant la, Ib respectivement. Par exemple deux sources de courant distinctes sont reliées chacune à un plot de contact situé sur la partie fixe 502 à proximité de poutres d'actionnement 506.1, 506.2. Les plots de contact sont isolés électriquement l'un de l'autre au niveau du substrat. Cette alimentation de chaque poutre d'actionnement par un courant différent est rendu possible par la présence de l'élément de liaison qui forme un chemin de conduction distinct des poutres d'actionnement, et permet aux courants la et Ib de circuler par l'élément de liaison vers la partie fixe. L'élément de liaison est donc traversé par le courant la + Ib.

Chaque courant la, Ib peut être contrôlé séparément et permettre la génération de forces électrothermiques différentes dans chaque poutre d'actionnement. Par exemple, les courants la et Ib peuvent être des signaux en créneaux en opposition de phase ou des courants sinusoïdaux par exemple également en opposition de phase. Il est alors possible d'avoir une interférence constructive des forces électrothermiques appliquées par les deux poutres d'actionnement alignées.

Comme expliqué pour la structure S1, l'auto-échauffement de l'élément de liaison 508 ne s'oppose pas au déplacement de la partie mobile 504, les bras de l'élément de liaison 508 pouvant se dilater librement.

Cet exemple de réalisation présente l'avantage de permettre la réalisation de structures dans lesquelles les deux poutres d'actionnement électrothermiques sont alignées, ce qui n'est pas envisageable dans les structures de l'état de la technique sinon les forces s'opposeraient.

En outre et de manière très avantageuse, la partie mobile peut être déplacée vers la droite ou vers la gauche à partir de sa position d'équilibre en activant l'une ou l'autre des poutres d'actionnement. Le courant d'activation I1 ou I2 circulant dans l'élément de liaison 508 et non dans l'autre poutre d'actionnement, il n'y a pas génération d'une force dans l'autre poutre d'actionnement qui s'opposerait au déplacement de la partie mobile. Dans les structures à actionnement électrothermique de tels déplacements dans un sens ou dans le sens opposé sur commande à partir d'une position d'équilibre ne sont pas envisageables.

Il sera compris que l'on peut remplacer chaque poutre d'actionnement par plusieurs poutres d'actionnement disposées en parallèle d'un point de vue électrique et qui seraient activées par la même source de courant.

Sur la figure 8, on peut voir un autre exemple de structure S7 pouvant être actionnée par deux courants d'actionnement.

La structure S7 est proche de la structure S4 mais elle comporte une deuxième poutre d'actionnement 606.2 alignée avec la poutre d'actionnement 606.1 et opposée à la poutre 606.1 par rapport à la partie mobile 604. Comme pour la structure S6 des courants Ia, Ib traversent les poutres d'actionnement 606.1, 606.2 respectivement et ensuite circulent vers la partie fixe par les éléments de liaison 608.1, 608.2. Les forces électrothermiques générées dans les éléments de liaison 608.1, 608.2 se compensent et ne perturbent pas le déplacement de la partie mobile.

Une structure comportant n poutres d'actionnement, n étant au moins égal à 2 et m éléments de liaison, m étant au moins égal à 1, et q sources de courants indépendantes, q étant compris entre 2 et n compris, circulant dans les n poutres d'actionnement, ne sort pas du cadre de la présente invention.

La mise en œuvre d'au moins deux poutres d'actionnement traversées par des courants différents peut par exemple être appliquée à la structure S6 dans laquelle la partie mobile est articulée en rotation dans le plan. Par exemple une deuxième poutre d'actionnement alignée avec la poutre d'actionnement 406 pourrait être prévue.

Dans tous les exemples de réalisation comportant plusieurs poutres d'actionnement et/ou plusieurs éléments de liaison, les poutres d'actionnement peuvent avoir des dimensions égales ou différentes et les éléments de liaison peuvent avoir des dimensions égales ou différentes et des formes similaires ou différentes.

Sur la figure 9A, on peut voir un autre exemple de réalisation d'une structure MEMS et/ou NEMS S8 dans laquelle la partie mobile est déformée mécaniquement par l'action de la poutre d'actionnement.

La structure S8 comporte une partie fixe 702, une partie mobile 704 et une poutre d'actionnement 706 s'étendant sur une direction X.

Dans l'exemple représenté, l'élément mobile s'étend selon une direction Y4 dans le plan et perpendiculaire à l'axe X. La parte mobile 704 est solidaire du substrat par une extrémité longitudinale 704.1 par une liaison encastrement 716. La partie mobile est dimensionnée pour pouvoir se déformer en flexion sous l'effet de la force électrothermique appliquée par la poutre d'actionnement.

La liaison encastrement remplace l'élément de liaison, le courant d'actionnement circulant à travers la poutre et la liaison encastrement.

Lorsqu'un courant d'actionnement circule dans la poutre d'actionnement 706, celle-ci s'auto-échauffe par effet Joule ce qui génère une force électrothermique qui s'applique sur la partie mobile 704. Du fait de la direction perpendiculaire de la force électrothermique par rapport à l'axe de la partie mobile, celle-ci se déforme en flexion comme cela est représenté en pointillés sur la figure 9A.

Toute autre orientation de la poutre d'actionnement par rapport à la partie mobile provoquant la déformation de la partie mobile selon un mode autre qu'un mode de flexion et/ou dans une direction hors-plan ne sort pas du cadre de la présente invention.

Sur la figure 9B, on peut voir un autre exemple de réalisation d'une structure S9 dans laquelle l'élément mobile 704 est également destiné à être déformée en flexion. La structure S9 comporte deux poutres d'actionnement 706.1 et 706.2, alignées dans l'exemple représentés et qui sont traversées par deux courants différents Ia, Ib.

Comme pour la structure S8, les poutres sont perpendiculaires à l'axe de l'élément mobile provoquant, en appliquant les forces électrothermiques, une déformation suivant un mode de flexion.

On peut prévoir que les poutres ne soient pas alignées provoquant alors plusieurs zones de déformation de la partie mobile.

Sur la figure 9C, on peut voir une structure similaire à celle des figures 5A et 5B mettant en œuvre deux poutres d'actionnement 206 disposées de part et d'autre de la partie mobile 904, l'activation de l'une ou l'autre des poutres permet de faire pivoter la partie mobile autour de l'axe de rotation dans le sens horaire et le sens antihoraire.

Sur la figure 10, on peut voir un autre exemple d'une structure MEMS et/ou NEMS S10 mettant en œuvre deux poutres d'actionnement.

La structure S10 comporte une partie fixe 802, une partie mobile 804, deux poutres d'actionnement 806.1, 806.2 parallèles et reliées à un même côté de la partie mobile et un élément de liaison 808 également relié au même côté de la partie mobile que les poutres d'actionnement. L'élément de liaison 808 présente une certaine élasticité permettant à la structure 804 de se déplacer dans le plan en translation selon X et permet le pivotement de de la masse autour de la direction Z.

Cette structure permet de contrôler finement les modes mécaniques que l'on souhaite exciter. Par exemple, l'amplitude et la phase dans le cas de signaux sinusoïdaux des courants traversant les poutres d'actionnement peuvent être adaptées afin de favoriser l'excitation d'un mode mécanique donné.

Par exemple, dans le cas de courants d'actionnement continus en phase dans les deux poutres d'actionnement 806.1, 806.2, la partie mobile 804 se déplace en translation le long de l'axe X. Dans le cas de courants d'actionnement continus en antiphase, la partie mobile est déplacée en rotation autour de l'axe Z.

On note $I_1$ le courant circulant dans la poutre 806.1 et I2 le courant circulant dans la poutre d'actionnement 806.2.

Dans le cas où des courants d'actionnement continus sont considérés, en écrivant $I_1 = i_a + i_b$ et $I_2 = i_a + \varepsilon \times i_b$, sachant que la force d'actionnement est proportionnelle au carré de l'intensité, les composantes de forces s'écrivent :

Pour la poutre 806.1 :

$$F_1 \propto i_a{}^2 + i_b{}^2 + 2i_a i_b$$

Pour la poutre 806.2 :

$F_2 \propto i_a^2 + i_b^2 + 2i_a i_b$ si $\varepsilon$ = 1, les deux forces sont alors en phase. Les deux poutres subissent le même auto-échauffement et des forces électrothermiques de même intensité sont générées, la partie mobile se déplace en translation. L'élément de liaison 808 se déforme selon la direction X.

$F_2 \propto i_a^2 + i_b^2 - 2i_a i_b$ si $\varepsilon$ = -1, les deux forces comportent alors un terme en antiphase. Les deux poutres ne subissent pas le même auto-échauffement et des forces électrothermiques d'intensités différentes sont générées, la partie mobile se déplace en rotation autour de l'axe Z. L'élément de liaison 808 se déforme autour de l'axe Z. La poutre d'actionnement dans laquelle est générée la force électrothermique la plus importante donne le sens de rotation de la partie mobile.

Dans le cas où des courants d'actionnement sinusoïdaux sont considérés, en écrivant $I_1 = i_a \sin \omega t$ et $I_2 = i_a \sin \omega t + \varphi$, on a

Pour la poutre 1 :

$$F_1 \propto i_a{}^2 \frac{1 - \cos 2\omega t}{2}$$

Pour la poutre 2 :

$$F_2 \propto i_a{}^2 \frac{1 - \cos 2\omega t + 2\varphi}{2}.$$

En choisissant $\varphi = \frac{\pi}{2}$ par exemple on obtient des forces $F_1$ et $F_2$ en opposition de phase pour la composante à $2\omega$ provoquant une rotation de la partie mobile.

Une composante en phase statique existe, il en résulte un décalage en position de la partie mobile par rapport à sa position d'équilibre.

En considérant la structure S7 de la figure 8 ou S6 de la figure 7, dans laquelle les deux poutres d'actionnement sont alignées de part et d'autre de la partie mobile, la résultante des forces en opposition de phase appliquée à la partie mobile peut s'écrire :

$$\sum F \propto \cos 2\omega t$$

La structure S6 permet de supprimer les composantes statiques.

Sur la figure 11, on peut voir un autre exemple de structure S11 à quatre poutres d'actionnement permettant également de supprimer les composantes statiques. La structure S11 comporte, par rapport à la structure S10, deux poutres d'actionnement supplémentaires, une poutre 806.3 alignée avec la poutre 806.1 et reliée au côté de la partie mobile 804 opposé à celui auquel est reliée la poutre 806.1 et une poutre 806.4 alignée avec la poutre 806.2 et reliée au côté de la partie mobile opposé à celui auquel est reliée la poutre 806.2.

Chaque poutre d'actionnement 806.1, 806.2, 806.3, 806.4 est alimentée par son propre courant d'actionnement I1, I2, I3, I4 respectivement. Chaque courant génère un auto-échauffement et des forces électrothermiques qui s'appliquent sur la partie mobile.

En appliquant, par exemple, des courants i1 et i3 sinusoïdaux en quadrature et des courant i2 et i4 quadrature, il est possible de supprimer les composantes statiques, la partie mobile 804 pouvant alors être déplacée en translation le long de l'axe X.

Si en outre, les courants i1 et i2 sont quadrature et i3 et i4 sont quadrature, la partie mobile 804 peut être excitée en rotation autour de l'axe Z.

Il sera compris qu'en choisissant une phase adaptée entre les courants circulant dans les différentes poutres d'actionnement, il est possible d'optimiser l'excitation d'un mode souhaité pour toute structure, par exemple dans le cas de structures comportant plusieurs parties mobiles, avec chacune plusieurs degrés de liberté.

En outre, de manière très avantageuse, les structure comportant au moins deux poutres d'actionnement telles que celles représentées sur les figures 7, 8, 9B et 11, peuvent permettre de compenser le flux thermique vu par la partie mobile et résultant de l'application du courant d'actionnement.

En effet dans une structure à actionnement électrothermique de l'état de la technique, l'application d'un signal sinusoïdal en tension ou en courant, un flux d'énergie thermique est appliqué à la structure ce qui provoque une modulation de température de la structure et en particulier de la partie mobile. Cette modulation peut avoir des effets sur la réponse mécanique de la structure en modifiant la raideur de l'élément de liaison.

Dans le cas à une application à un capteur de pression asservi, cette modulation de température peut chauffer le gaz dont la pression varie avec la température. Une telle modulation en température perturbe les mesures.

Une structure à au moins deux poutres d'actionnement alimentées par des courants différents peut permettre d'éviter, ou au moins de limiter, cette modulation en température de la structure.

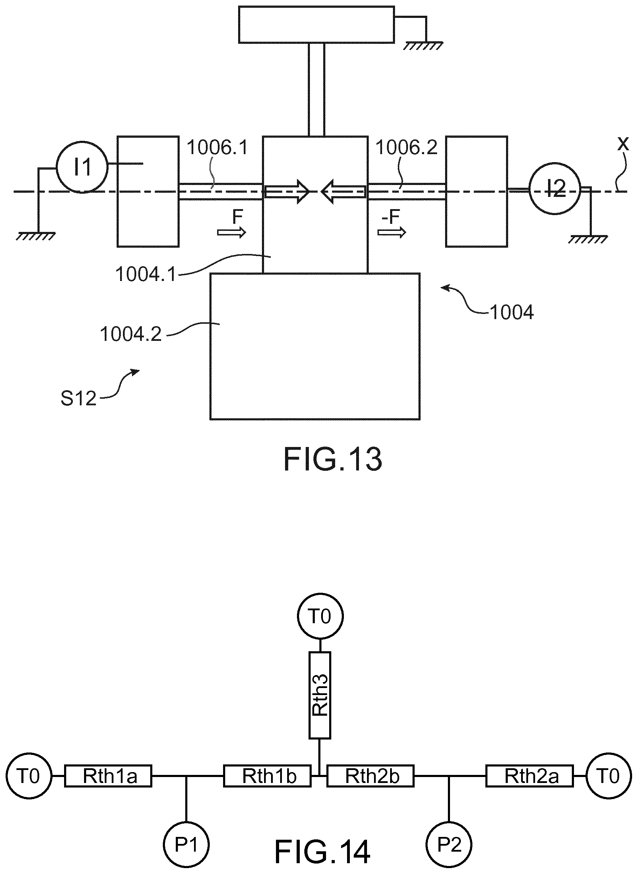

Sur la figure 13, on peut voir une structure S12 qui se rapproche de la structure S6. Dans la structure S12, l'élément de liaison est droit et non sous forme de ressort en créneau. Les poutres d'actionnement sont alignées le long de l'axe X de part et d'autre de la partie mobile 1004. De manière très avantageuse, les extrémités longitudinales des poutres d'actionnement 1006 qui sont ancrées sur la partie mobile 1004 sont situées à une courte distance l'une de l'autre. Dans l'exemple représenté, la partie mobile 1004 comporte une partie étroite 1004.1 dans le sens de la direction X entre les deux poutres d'actionnement 1006.1, 1006.2, et une partie plus large 1004.2 située en dehors de l'espace entre les poutres. La partie 1004.2 peut former la partie fonctionnelle de la partie mobile 1004 et la partie 1004.1 former la partie d'actionnement ou d'excitation. Les extrémités d'ancrage des poutres d'actionnement 1006.1, 1006.2 sur la partie mobile 1004 sont donc rapprochés. La distance séparant les ancrages est par exemple 5 fois inférieure à la dimension de la partie mobile dans la direction d'alignement des ancrages, elle est par exemple comprise entre 10 nm et 50 $\mu$m, de préférence entre 1 $\mu$m et 50 $\mu$m, par exemple égale à 10 $\mu$m.

On applique à la poutre d'actionnement 1006.1 un courant de sorte à provoquer un échauffement de la poutre $T_0 + \Delta T$ et on applique à la poutre d'actionnement 1006.2 un courant de sorte à provoquer un échauffement de la poutre $T_0 - \Delta T$.

Sur la figure 14, on peut voir le circuit thermique de la structure S12.

Rth1a est donnée par la résistance thermique de la poutre d'actionnement 1006.1, Rth2a est donnée par la résistance thermique de la poutre d'actionnement 1006.2, Rth1b et Rth2b sont des résistances thermiques qui comportent une contribution des poutres d'actionnement 1006.1 et 1006.2 et de la partie mobile 1004. Rth3 est la résistance thermique de l'élément de liaison.

Par effet Joule, les poutres d'actionnement produisent des flux thermiques P1 et P2 respectivement. Les flux au niveau de la partie mobile se compensent parfaitement si Rth1a=Rth2a et Rth1b=Rth2b pour des niveaux puissance identiques.

On annule donc les composantes variables. La structure est alors échauffée à température constante.

Les courants peuvent être sous la forme :

$$I_1 = i_0 + i_m(t) \text{ pour la poutre 1006.1,}$$

$$I_2 = i_0 - i_m(t) \text{ pour la poutre 1006.2}$$

On a alors $\Delta T = 2i_0 i_m$ et $T_0 \propto i_0{}^2 + i_m{}^2 \sim i_0{}^2$ si $i_0 \gg i_m$. On peut en effet, pour un échauffement donné $\Delta T$, augmenter $i_0$ et prendre $i_m \propto \dfrac{1}{i_0}$ pour réduire la composante non compensée. Idéalement, les courants sont de la forme, en prenant $i_0 > i_m(t)$ :

$$I_1 = i_0 \sqrt{1 + \frac{i_m(t)}{i_0}} \text{ pour la poutre 1006.1}$$

$$I_2 = i_0 \sqrt{1 - \frac{i_m(t)}{i_0}} \text{ pour la poutre 1006.2}$$

En cas d'excitation harmonique, il est avantageux de prendre :

$I_1 = i_a \sin \omega t$ pour la poutre 1006.1,
$I_2 = i_a \cos \omega t$ pour la poutre 1006.2.

Qui produisent les échauffements :

Pour la poutre 1006.1 : $T_1 \propto \dfrac{1 + \cos 2\omega t}{2}$

Pour la poutre 1006.2 : $T_2 \propto \dfrac{1 - \cos 2\omega t}{2}$

On a alors $\Delta T \propto \cos 2\omega t$ et $T_0$ est une constante.
Le flux thermique injecté dans la structure ne conserve que sa composante statique, il est donc constant : en effet le flux est proportionnel à la somme $I_1(t)^2 + I_2(t)^2 = i_a{}^2$ qui est constant.
La structure et en particulier la partie mobile 1004 ne subissent pas de modulation en température. Elle est échauffée à une température donnée qui peut être prise en compte dans le dimensionnement de la structure ou l'actionnement de celle-ci et/ou dans le traitement des signaux qu'elle transmet pour compenser cette élévation constante de température.
En variante, on pourrait modifier l'amplitude de l'un et/ou l'autre des courants traversant les poutres d'actionnement pour supprimer ou au moins réduire la composante dynamique du flux thermique résultant s'appliquant à la structure.
Cette compensation de flux thermique peut être très avantageuse lorsque la structure comporte des moyens de détection du déplacement de la partie mobile par exemple dans le cas d'un capteur, et plus généralement lorsque la structure comporte des organes de transduction sensibles à la température.

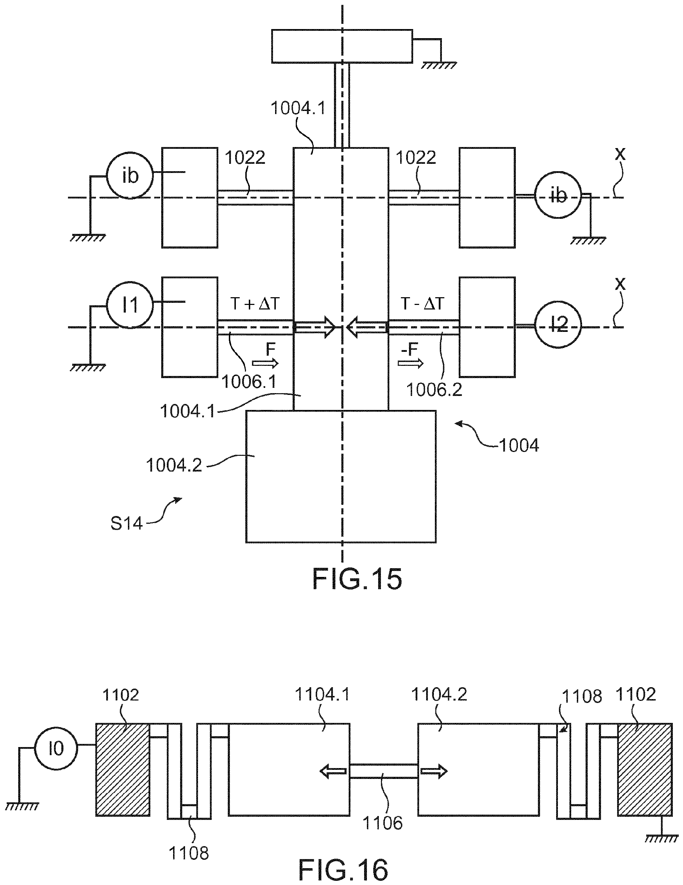

Sur la figure 15, on peut voir une structure S14 très proche de la structure S12, comportant en plus des moyens de transduction piézorésistifs 1022 ou jauges piézorésistives. Ces jauges sont sensibles aux variations de température. Dans l'exemple représenté, les jauges sont suspendues entre la partie fixe 1002 et la partie étroite 1004.1 de la partie mobile 1004 parallèlement aux poutres d'actionnement et de part et d'autre de la partie mobile, permettant par exemple une mesure différentielle.
Les courants I1 et I2 traversent les poutres d'actionnement 1006.1, 1006.2.
Lorsque les flux thermiques générés par les poutres d'actionnement 1006.1, 1006.2 sont compensés au niveau de la partie mobile comme cela a été décrit en relation avec les figures 13 et 14, il n'y a pas de modulation de température qui se transmette aux jauges par la partie mobile, la modulation de température synchrone avec le mouvement de la partie mobile est alors fortement réduite, ce qui a pour effet de réduire fortement le signal thermique, également appelé fond de mesure, au niveau des jauges piézorésistives. L'échauffement à une température constante des jauges est pris en compte dans le traitement des signaux qu'elles génèrent.
Le courant de polarisation ib des jauges peut être soit statique, soit modulée à une fréquence $\omega_b$ différente de la fréquence de vibration mécanique afin de ne pas générer de composante de fond qui se superpose au signal mécanique, puisqu'un effet joule apparaît également au sein des jauges. En revanche, une composante thermique peut être générée à $\omega_b$ et ses harmoniques sur la structure. Le courant de polarisation des jauges peut toutefois être choisi suffisamment faible pour limiter les effets indésirables sur la structure.

De manière très avantageuse, les poutres d'actionnement peuvent être utilisées également pour mesurer les mouvements de la partie mobile en exploitant les propriétés de piézorésistivité du matériau de la poutre. Les fonctions d'actionnement et de détection peuvent ainsi être fournies par la même poutre. Ceci permet de réduire le nombre de plots de connexion extérieurs qui imposent des contraintes sévères sur les tailles du composant, en effet des plots de 50 x 50 μm peuvent être nécessaires pour assurer une connexion filaire. L'encombrement de la structure est encore réduit et sa réalisation est simplifiée.

Dans tous les exemples représentés, les plots peuvent être polarisés en tension ou contrôlés en courant afin d'adapter les niveaux de courants qui traversent les poutres d'actionnement.

Dans tous les exemples de réalisation, les structures peuvent comporter plusieurs parties mobiles déplacées par une ou plusieurs poutres d'actionnement activées par une ou plusieurs sources de courant ou de tension. Sur la figure 16, on peut voir un exemple de structure dans laquelle une poutre d'actionnement 1106 est connectée directement à deux parties mobiles 1104.1, 1104.2 et non directement à une partie fixe et à une partie mobile, les parties mobiles 1104.1, 1104.2 étant suspendues à la partie fixe 1102, par des moyens de suspension 1108 permettant de conduire le courant jusqu'à la poutre d'actionnement. Plusieurs poutres d'actionnement pourraient être prévues. Cette structure permet de privilégier des modes de vibration des parties mobiles en opposition de phase.

Grâce au très faible encombrement de la structure selon l'invention et de son rendement énergétique élevé, l'invention est particulièrement adaptée à l'intégration dans des dispositifs portables et dans des capteurs que l'on cherche à miniaturiser.

La ou les poutres d'actionnement peuvent être utilisées pour faire de l'auto test, par exemple pour des microphones, des accéléromètres, etc. Un microphone ou un accéléromètre ne nécessite pas de moyens d'actionnement pour son fonctionnement. Néanmoins on peut prévoir de tels moyens d'actionnement pour s'assurer de l'intégrité de la réponse mécanique de la structure mobile. En utilisant les jauges de détection comme moyen d'actionnement, il est possible de répondre à cette problématique sans ajouter des plots de connexion vers des électrodes d'actionnement et ainsi réduire les contraintes sur les dimensions du composant. Du fait du faible encombrement des poutres à actionnement électrothermique s leur intégration n'est pas ou peu problématique.

Les poutres d'actionnement peuvent être utilisées pour compenser des efforts importants produits par des accélérations par exemple. L'asservissement par des moyens d'actionnement capacitif peut dans certain cas exiger des niveaux de tension très élevés difficilement disponibles pour des plateformes autonomes ou nomades. Grâce à la présente invention, du fait de l'intensité élevée de la force électrothermique qui peut être obtenue, un tel asservissement peut être envisagé.

La structure MEMS et/ou NEMS est réalisée par des techniques de la microélectronique et/ou de la nanoélectronique bien connues de l'homme du métier.

L'invention peut permettre de réaliser des gyromètres, les poutres servant à exciter la ou les parties mobiles du gyromètre et éventuellement à détecter leur déplacement.

L'invention peut être utilisée dans le domaines des capteurs et actionneurs résonants, par exemple pour réaliser des oscillateurs pour les bases de temps, la détection de masse biochimique, etc. et dans domaine des systèmes utilisant des actionneurs requérant la génération de forces importantes afin de positionner ou déplacer un élément mécanique, tel qu'un interrupteur, un miroir, ou pour compenser des efforts extérieurs via une boucle de rétroaction, par exemple dans des accéléromètres, gyromètres asservis.

## Revendications

1. Structure microélectromécanique et/ou nanoélectromécanique à actionnement électrothermique comportant une partie fixe (2), au moins une partie mobile (4) par rapport à la partie fixe (2), au moins un ensemble de plusieurs poutres d'actionnement (6.1, 6.2, 6.3, 6.4) électrothermiques permettant de faire circuler un courant électrique de la partie fixe à la partie mobile et reliée mécaniquement à la partie mobile (4) et aptes à appliquer simultanément une force électrothermique de même sens sur la partie mobile, et au moins un élément de liaison électriquement conducteur (8) reliant électriquement la partie mobile (4) à la partie fixe (2), **caractérisée en ce que** l'ensemble de plusieurs poutres d'actionnement (6.1, 6.2, 6.3, 6.4) électrothermiques présente une épaisseur (e3) inférieure ou égale à la moitié d'une épaisseur (e2) de la partie mobile (4) et inférieure ou égale à la moitié d'une épaisseur de l'élément de liaison (8) et **en ce que** les poutres d'actionnement sont des nanofils.

2. Structure selon la revendication 1, dans laquelle l'épaisseur et/ou la largeur des poutres d'actionnement est inférieure ou égale à 500 nm.

3. Structure selon la revendication 1 ou 2, dans laquelle les poutres d'actionnement (6.1, 6.2, 6.3, 6.4) électrothermiques comportent un ou plusieurs matériaux thermoélastiques aptes à se déformer sous l'effet d'un échauffement thermique induit par effet Joule par le courant électrique destiné à circuler dans lesdites poutres.

**4.** Structure selon l'une des revendications 1, 2 ou 3, dans laquelle les poutres d'actionnement électrothermiques (6.1, 6.2, 6.3, 6.4) présentent un rapport de forme compris entre 1 et 2.

**5.** Structure selon l'une des revendications 1 à 4, dans laquelle l'élément de liaison (8) présente une forme telle qu'une force électrothermique générée en son sein ne s'oppose pas ou peu à la force électrothermique générée dans les poutres d'actionnement (6.1, 6.2, 6.3, 6.4).

**6.** Structure selon la revendication 5, dans laquelle l'élément de liaison (8) a la forme d'un ressort replié selon des créneaux, ou dans laquelle l'élément de liaison s'étend suivant un axe perpendiculaire à un axe auquel les poutres d'actionnement sont parallèles.

**7.** Structure selon la revendication 5, comportant deux éléments de liaison alignés le long d'un axe perpendiculaire à un axe auquel les poutres d'actionnement sont parallèles.

**8.** Structure selon l'une des revendications 1 à 7, comportant une articulation en rotation entre la partie fixe et la partie mobile et dans laquelle les poutres d'actionnement sont disposées par rapport à la partie mobile de sorte à provoquer sa rotation par rapport à la partie fixe, ladite rotation étant dans le plan de la structure ou hors-plan.

**9.** Structure selon les revendications 6 ou 7 et 8, dans laquelle l'articulation en rotation comporte l'élément de liaison ou les éléments de liaison alignés définissant l'axe de rotation, le ou lesdits éléments de liaison étant déformables en torsion et dans laquelle les poutres d'actionnement sont reliées mécaniquement à la partie mobile de sorte que les forces électrothermiques générées dans les poutres d'actionnement provoquent la rotation hors-plan de la partie mobile.

**10.** Structure selon la revendication 8, dans laquelle l'articulation en rotation comporte deux éléments de liaison dont les axes sont sécants.

**11.** Structure selon l'une des revendications 1 à 7, dans laquelle la partie mobile est reliée mécaniquement à la partie fixe par un ancrage, ledit ancrage formant un élément de liaison et dans laquelle les poutres d'actionnement sont orientées par rapport à la partie mobile pour provoquer sa déformation élastique.

**12.** Structure selon l'une des revendications 1 à 11, dans laquelle l'épaisseur (e2) de la partie mobile (4) et l'épaisseur (e4) de l'élément de liaison (8) sont égales.

**13.** Structure selon l'une des revendications 1 à 12, comportant en outre des moyens de détection d'un déplacement de la partie mobile, lesdits moyens de détection étant avantageusement sont des moyens piézorésistifs, et/ou les moyens de détection étant avantageusement formés par une ou plusieurs poutres d'actionnement.

**14.** Actionneur comportant au moins une structure selon l'une des revendications 1 à 13.

**15.** Capteur comportant au moins une structure selon l'une des revendications 1 à 13.

**Patentansprüche**

**1.** Mikroelektromechanische und/oder nanoelektromechanische Struktur zur elektrothermischen Betätigung, umfassend einen festen Teil (2), wenigstens einen bezüglich des festen Teils (2) beweglichen Teil (4), wenigstens eine Anordnung aus mehreren elektrothermischen Betätigungsbalken (6.1, 6.2, 6.3, 6.4), welche es erlauben, einen elektrischen Strom von dem festen Teil zu dem beweglichen Teil fließen zu lassen, und mechanisch mit dem beweglichen Teil (4) verbunden und dazu in der Lage, gleichzeitig eine elektrothermische Kraft vom gleichen Sinn auf den beweglichen Teil auszuüben, und wenigstens ein elektrisch leitfähiges Verbindungselement (8), welches den beweglichen Teil (4) mit dem festen Teil (2) verbindet, **dadurch gekennzeichnet, dass** die Anordnung aus mehreren elektrothermischen Betätigungsbalken (6.1, 6.2, 6.3, 6.4) eine Dicke (e3) aufweist, welche kleiner oder gleich der Hälfte einer Dicke (e2) des beweglichen Teils (4) und kleiner oder gleich der Hälfte einer Dicke des Verbindungselements (8) ist, und dass die Betätigungsbalken Nanofasern sind.

**2.** Struktur nach Anspruch 1, wobei die Dicke und/oder die Breite der Betätigungsbalken kleiner oder gleich 500 nm ist.

**3.** Struktur nach Anspruch 1 oder 2, wobei die elektrothermischen Betätigungsbalken (6.1, 6.2, 6.3, 6.4) ein oder mehrere thermoelastische Materialien umfassen, welche in der Lage sind, sich unter der Wirkung einer thermischen Erwärmung zu verformen, welche durch den Joule-Effekt durch den elektrischen Strom hervorgerufen wird, welcher dazu vorgesehen ist, in den Balken zu fließen.

**4.** Struktur nach einem der Ansprüche 1, 2 oder 3, wobei die elektrothermischen Betätigungsbalken (6.1, 6.2, 6.3, 6.4) ein Formverhältnis zwischen 1 und 2 aufweisen.

**5.** Struktur nach einem der Ansprüche 1 bis 4, wobei das Verbindungselement (8) eine derartige Form aufweist, dass eine in seinem Inneren erzeugte elektrothermische Kraft sich nicht oder nur wenig der elektrothermischen Kraft entgegenstellt, welche in den Betätigungsbalken (6.1, 6.2, 6.3, 6.4) erzeugt wird.

**6.** Struktur nach Anspruch 5, wobei das Verbindungselement (8) die Form einer gemäß Abständen gefalteten Feder aufweist, oder wobei sich das Verbindungselement einer Achse senkrecht zu einer Achse folgend erstreckt, zu welcher die Betätigungsbalken parallel sind.

**7.** Struktur nach Anspruch 5, umfassend zwei Verbindungselemente, welche entlang einer Achse senkrecht zu einer Achse ausgerichtet sind, zu welcher die Betätigungsbalken parallel sind.

**8.** Struktur nach einem der Ansprüche 1 bis 7, umfassend ein Rotationsgelenk zwischen dem festen Teil und dem beweglichen Teil, und wobei die Betätigungsbalken bezüglich des beweglichen Teils derart angeordnet sind, dass seine Rotation bezüglich des festen Teils hervorgerufen wird, wobei die Rotation in der Ebene der Struktur oder aus der Ebene heraus ist.

**9.** Struktur nach Anspruch 6 oder 7 und 8, wobei das Rotationsgelenk das Verbindungselement oder die Verbindungselemente umfasst, welche die Rotationsachse definierend ausgerichtet sind, wobei das oder die Verbindungselemente in Torsion verformbar sind, und wobei die Betätigungsbalken mechanisch mit dem beweglichen Teil derart verbunden sind, dass die in den Betätigungsbalken erzeugten elektrothermischen Kräfte die Rotation des beweglichen Teils aus der Ebene heraus hervorrufen.

**10.** Struktur nach Anspruch 8, wobei das Rotationsgelenk zwei Verbindungselemente umfasst, deren Achsen Sekanten sind.

**11.** Struktur nach einem der Ansprüche 1 bis 7, wobei der bewegliche Teil mechanisch an dem festen Teil durch eine Verankerung angebracht ist, wobei die Verankerung ein Verbindungselement bildet, und wobei die Betätigungsbalken bezüglich des beweglichen Teils zum Hervorrufen seiner elastischen Verformung orientiert sind.

**12.** Struktur nach einem der Ansprüche 1 bis 11, wobei die Dicke (e2) des beweglichen Teils (4) und die Dicke (e4) des Verbindungselements (8) gleich sind.

**13.** Struktur nach einem der Ansprüche 1 bis 12, ferner umfassend Mittel zum Detektieren einer Verlagerung des beweglichen Teils, wobei die Mittel zum Detektieren vorzugsweise piezoresistive Mittel sind und/oder die Mittel zum Detektieren vorzugsweise durch einen oder mehrere Betätigungsbalken gebildet sind.

**14.** Aktuator, umfassend wenigstens eine Struktur nach einem der Ansprüche 1 bis 13.

**15.** Sensor, umfassend wenigstens eine Struktur nach einem der Ansprüche 1 bis 13.

**Claims**

**1.** An electrothermally actuated microelectromechanical and/or nanoelectromechanical structure comprising a fixed part (2), at least one movable part (4) being movable with respect to the fixed part (2), at least one set of several electrothermal actuation beams (6.1, 6.2, 6.3, 6.4) for flowing an electric current from the fixed part to the movable part and mechanically connected to the movable part (4) and able to simultaneously apply an electrothermal force having the same direction on the movable part, and at least one electrically conducting connecting element (8) electrically connecting the movable part (4) to the fixed part (2), **characterized in that** the set of several electrothermal actuation beams (6.1, 6.2, 6.3, 6.4) has a thickness (e3) lower than or equal to half a thickness (e2) of the movable part (4) and lower than or equal to half a thickness of the connecting element (8) and in which the actuation beams are nanowires.

2. The structure according to claim 1, wherein the thickness and/or width of the actuation beams is lower than or equal to 500 nm.

3. The structure according to claim 1 or 2, wherein the electrothermal actuation beams (6.1, 6.2, 6.3, 6.4) comprise one or more thermoelastic materials able to be deformed under the effect of a Joule-effect induced heating by the electric current for flowing in said beams.

4. The structure according to one of claims 1, 2 and 3, wherein the electrothermal actuation beams (6.1, 6.2, 6.3, 6.4) have an aspect ratio between 1 and 2.

5. The structure according to one of claims 1 to 4, wherein the connecting element (8) has a shape such that an electrothermal force generated therewithin opposes little or not the electrothermal force generated in the actuation beams (6.1, 6.2, 6.3, 6.4).

6. The structure according to claim 5, wherein the connecting element (8) is in the shape of a spring folded as slots or wherein the connecting element extends along an axis perpendicular to an axis to which the actuation beams are parallel.

7. The structure according to claim 5, comprising two connecting elements aligned along an axis perpendicular to an axis to which the actuation beams are parallel.

8. The structure according to one of claims 1 to 7, comprising a rotational hinge between the fixed part and the movable part and wherein the actuation beams are disposed with respect to the movable part so as to cause its rotation with respect to the fixed part, said rotation being in- or out-of-plane of the structure.

9. The structure according to one of claims 6 or 7 and 8, wherein the rotational hinge comprises the aligned connecting element(s) defining the axis of rotation, said connecting element(s) being torsionally deformable and wherein the actuation beams are mechanically connected to the movable part such that the electrothermal forces generated in the actuation beams cause the out-of-plane rotation of the movable part.

10. The structure according to claim 8, wherein the rotational hinge comprises two connecting elements the axes of which are secant.

11. The structure according to one of claims 1 to 7, wherein the movable part is mechanically connected to the fixed part by an anchor, said anchor forming a connecting element and wherein the actuation beams are oriented with respect to the movable part to cause its elastic deformation.

12. The structure according to one of claims 1 to 11, wherein the thickness (e2) of the movable part (4) and the thickness (e4) of the connecting element (8) are equal.

13. The structure according to one of claims 1 to 12, further comprising means for detecting a movement of the movable part, the means for detecting being advantageously are piezoresistive means and/or th means for detecting being advantageously formed by one or more actuation beams.

14. An actuator comprising at least one structure according to one of claims 1 to 13.

15. A sensor comprising at least one structure according to one of claims 1 to 13.

FIG.1A

FIG.1B

FIG.2

FIG.3A

FIG.3B

FIG.4A

FIG.4B

FIG.5A

FIG.5B

FIG.9C

FIG.6

FIG.7

FIG.8

FIG.9A

FIG.9B

FIG.10

FIG.11

FIG.12

FIG.13

FIG.14

**FIG.15**

**FIG.16**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015047078 A

- US 6675578 B

**Littérature non-brevet citée dans la description**

- **RAHAFROOZ A, ; POURKAMALI S.** Thermal-Piezoresistive Energy Pumps in Micromechanical Resonant Structures. *IEEE Trans Electron Devices.*, Décembre 2012, vol. 59 (12), 3587-93
- Gas Sensing using thermally actuated dual plate resonators and self-sustained oscillators. **XIABOBO GUO ; YUN-BO YI ; RAHAFROOZ A ; POURKAMALI.** Frequency Control Symposium (FCS). IEEE International, 2012, 1-5

- **RAHAFROOZ A ; POURKAMALI S.** Thermal-Piezoresistive Energy Pumps in Micromechanical Resonant Structures. *IEEE Trans Electron Devices,* Décembre 2012, vol. 59 (12), 3587-93